## Europäisches Patentamt

## European Patent Office

## Office européen des brevets

(11) Publication number: **0 170 848**
**B1**

(12) **EUROPEAN PATENT SPECIFICATION**

(45) Date of publication of patent specification: **07.11.90**

(51) Int. Cl.⁵: **H 01 L 21/268, H 01 L 21/28**

(21) Application number: **85107740.4**

(22) Date of filing: **24.06.85**

(54) **Thermal annealing of integrated circuits.**

(30) Priority: **30.07.84 US 635391**

(43) Date of publication of application:
**12.02.86 Bulletin 86/07**

(45) Publication of the grant of the patent:
**07.11.90 Bulletin 90/45**

(84) Designated Contracting States:
**DE FR GB**

(56) References cited:
**US-A-3 336 661**
**APPLIED PHYSICS LETTERS, vol. 41, no. 2, July 1982, pages 162-164, American Institute of Physics, New York, US; I.W. BOYD et al.: "Oxidation of silicon surfaces by CO2 lasers"**
**APPLIED PHYSICS LETTERS, vol. 38, no. 12, June 1981, pages 1005-1007, American Institute of Physics, New York, US; YUNG S. LIU et al.: "Rapid oxidation via adsorption of oxygen in laser-induced amorphous silicon"**
**JOURNAL OF APPLIED PHYSICS, vol. 52, no. 9, September 1981, pages 5691-5695, American Institute of Physics, New York, US; S.K. LAI et al.: "Reduction of electron trapping in silicon dioxide by high-temperature nitrogen anneal"**

(73) Proprietor: **International Business Machines Corporation**
**Old Orchard Road**
**Armonk, N.Y. 10504 (US)**

(72) Inventor: **Weinberg, Zeev Avraham**
**10 Soundview Circle**
**White Plains New York 10601 (US)**
Inventor: **Young, Donald Reeder**
**14 Briarbrook Road**
**Ossining New York 10562 (US)**

(74) Representative: **Hobbs, Francis John**
**IBM United Kingdom Limited Intellectual Property Department Hursley Park**
**Winchester Hampshire SO21 2JN (GB)**

(56) References cited:
**IEEE TRANSACTIONS ON ELECTRON DEVICES, vol. ED-27, no. 5, May 1980, pages 964-969, IEEE, New York, US; G. YARON et al.: "Application of laser processing for improved oxides grown from polysilicon"**

Courier Press, Leamington Spa, England.

## Description

This invention relates to integrated circuit production, and more particularly to a method of thermally annealing such circuits.

The prior art techniques for annealing integrated circuits to enhance the electronic properties of the silicon dioxide insulating layers comprised the use of long anneal times, typically over at least one hour, at 1000°C. We have found that the use of these long anneal times, particularly for silicon dioxide insulators in MOS device wafers, do not provide the desired enhancement of electronic properties.

It is therefore an object of the invention to enhance the electronic properties of silicon dioxide layers in metal oxide semiconductor devices, decreasing hole trapping and thereby increasing radiation hardness, by means of a rapid thermal annealing of the integrated circuit wafer at a stage during production when the silicon dioxide layer is exposed.

It is another object of the invention to improve the dielectric breakdown properties of such silicon dioxide insulating layers.

A feature of the invention is rapid heating (e.g. within a few seconds or less) of a semicondutor chip or wafer by controlled application of radiation from a high intensity halogen lamp, so as to carry out an annealing process without disruption of other processes or long waiting periods.

The advantage of the invention is its high quality and convenience; its production of the desired enhancements, increased radiation hardness and reduced hole trapping, are achieved without the extra effort and additional chance of contamination or unwanted diffusion inherent in longer anneals.

US-A-3336661 discloses a process in which charge carrier traps in a thin silicon dioxide layer formed on a silicon wafer are reduced by heating the wafer in dry oxygen at a temperature of 700° to 1300°C for a period from about 2 minutes to 10 hours.

The invention provides a process for enhancing electronic properties in a thin silicon dioxide insulating layer on an integrated circuit wafer comprising:-

(a) annealing the wafer in a nitrogen atmosphere so as to provide nitrogen atoms at the silicon-silicon dioxide interface.

(b) positioning the wafer inside an enclosure;

(c) charging said enclosure with oxygen;

(d) quickly heating the wafer by radiation heating to a suitable annealing temperature; and

(e) maintaining the wafer at that temperature for less than 300 seconds.

The foregoing and other objects, features and advantages of the invention will be apparent from the more particular description of the preferred embodiments of the invention, as illustrated in the accompanying drawings.

Brief Description of the Drawings

FIG. 1 is a schematic diagram of appropriate apparatus.

FIG. 2 is a graph showing hole trapping.

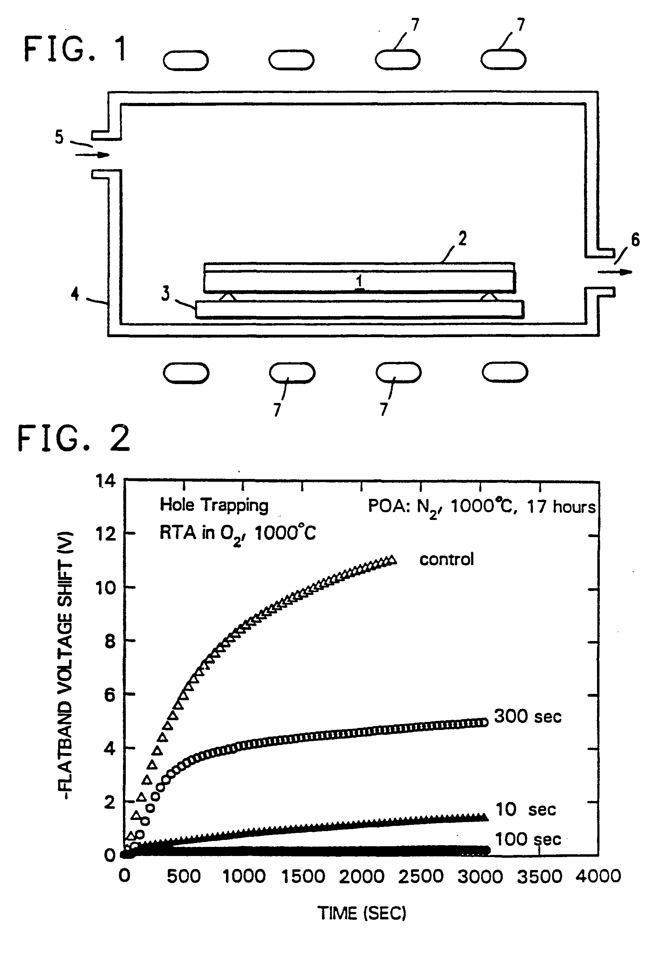

The invention provides a process for producing a silicon dioxide insulator film on a MOS integrated circuit wafer which film has reduced hole trapping characteristics. FIG. 1 shows typical apparatus used in the process. The silicon semiconductor wafer 1 has silicon dioxide insulator 2 on its surface, which surface will subsequently have conductors deposited upon it. The wafer is supported on a quartz plate 3 and inserted into a quartz enclosure 4. The desired gas, oxygen, is passed into this enclosure at inlet port 5 and escapes at exit port 6. An array of lamps 7, which are typically tungsten halogen lamps, are turned on to heat wafer 1 rapidly (e.g. 2 or 3 seconds) to the desired annealing temperature for a short time.

The anneal of a silicon dioxide film of thickness on the order of 10-100nm (100-1000 Angstroms) is carried out in an atmosphere of oxygen at atmospheric pressure. The preferred temperature and duration are 1000°C for 100 seconds; the range 10-300 seconds is effective, with a peak around 100 seconds.

FIG. 2 shows the reduction in hole trapping achieved by the rapid thermal annealing; it is a graph of flatband voltage shifts as a function of hole injection time in MOS capacitor structures. The flatband voltage shifts are proportional to the amount of hole trapping in the silicon dioxide. The control curve shows high trapping in oxides before annealing. Other curves, labelled with annealing time for rapid thermal annealing (RTA) show improvement in the form of reduced hole trapping. In particular, the curve for 100 seconds shows drastically reduced hole trapping, approaching the O trapping level.

Improved RTA annealing characteristics are found when the RTA is subsequent to a nitrogen pretreatment, such as a long pre oxidation anneal in nitrogen, which provides nitrogen atoms at the silicon-silicon dioxide interface. Such nitrogen pretreatment may typically be a pre-oxidation anneal (POA) of seventeen hours in nitrogen at 1000°C.

## Claims

1. A process for enhancing electronic properties in a thin silicon dioxide insulating layer on an integrated circuit wafer comprising the successive steps of:-

(a) annealing the wafer in a nitrogen atmosphere so as to provide nitrogen atoms at the silicon-silicon dioxide interface;

(b) positioning the wafer inside an enclosure;

(c) charging said enclosure with oxygen;

(d) quickly heating the wafer by radiation heating to a suitable annealing temperature; and

(e) maintaining the wafer at that temperature for less than 300 seconds.

2. A process as claimed in claim 1, in which the annealing temperature in step (d) is of the order of 1000°C.

3. A process as claimed in claim 1 or 2, in which the wafer is maintained at the annealing temperature in step (d) for more than 10 seconds.

4. A process as claimed in claim 1, 2 or 3, in which the wafer is maintained at the annealing temperature in step (d) for more than 100 seconds.

5. A process as claimed in claim 1, 2, 3 or 4, comprising maintaining a flow of oxygen through the enclosure.

6. A process as claimed in any preceding claim, in which the wafer is annealed in the nitrogen atmosphere in step (a) for about 17 hours.

7. A method of manufacturing a MOS device, which method includes a process as claimed in any one of claims 1 to 6.

## Patentansprüche

1. Verfahren zur Verbesserung elektronischer Eigenschaften in einer dünnen Siliziumdioxid-Isolierschicht auf einer Scheibe mit integriertem Schaltkreis, enthaltend die folgenden Schritte:

(a) Ausglühen der Scheibe in einer Stickstoffatmosphäre zur Bereitstellung von Stickstoffatomen auf der Silizium-Siliziumdioxid-Schnittstelle;

(b) Anbringung der Scheibe innerhalb einer Kapsel;

(c) Ladung der genannten Kapsel mit Sauerstoff;

(d) Schnelle Erhitzung der Scheibe durch Strahlungsaufheizung bis zu einer angemessenen Glühtemperatur; und

(e) Festhalten der Scheibe bei dieser Temperatur während weniger als 300 Sekunden.

2. Verfahren nach Anspruch 1, in welchem die Glühtemperatur des Schrittes (d) in der Grössenordnung von 1000°C liegt.

3. Verfahren nach Anspruch 1 oder 2, in welchem die Scheibe bei der Glühtemperatur des Schrittes (d) während mehr als 10 Sekunden festgehalten wird.

4. Verfahren nach Anspruch 1, 2 oder 3, in welchem die Scheibe auf der Glühtemperatur des Schrittes (d) während mehr als 100 Sekunden festgehalten wird.

5. Verfahren nach Anspruch 1, 2, 3 oder 4, enthaltend die Aufrechterhaltung eines Sauerstoffflusses durch die Kapsel hindurch.

6. Verfahren nach einem der vorangehenden Ansprüche, in welchem die Scheibe in der Stickstoffatmosphäre des Schrittes (a) ca. 17 Stunden lang ausgeglüht wird.

7. Verfahren zur Herstellung einer MOS-Vorrichtung, wobei dieses Verfahren einen Vorgang nach einem der vorangehenden Ansprüche 1 bis 6 enthält.

## Revendications

1. Procédé pour l'amélioration des propriétés électroniques d'une couche isolante mince de dioxyde de Silicium sur une pastille de circuit intégré, comprenant les opérations successives de:

(a) recuit de la pastille dans une atmosphère d'azote de façon à fournir des atomes d'azote à l'interface silicium-dioxyde de Silicium;

(b) introduction de la pastille dans une enceinte;

(c) remplissage de ladite enceinte en oxygène;

(d) chauffage rapide de la pastille au moyen d'un chauffage par rayonnement, à une température de recuit appropriée; et

(e) maintien de la pastille à cette température pendant moins de 300 secondes.

2. Procédé suivant la revendication 1, dans lequel la température de recuit à l'étape (d) est de l'ordre de 1000°C.

3. Procédé suivant la revendication 1 ou 2, dans lequel la pastille est maintenue à la température de recuit, à l'étape (d), pendant plus de 10 secondes.

4. Procédé suivant la revendication 1, 2 ou 3, dans lequel la pastille est maintenue à la température de recuit, à l'étape (d), pendant plus de 100 secondes.

5. Procédé suivant la revendication 1, 2,3 ou 4, comprenant le maintien d'une circulation d'oxygène à travers l'enceinte.

6. Procédé suivant l'une quelconque des revendications précédentes, dans lequel la pastille est recuite dans l'atmosphère d'azote, à l'étape (a), pendant 17 heures environ.

7. Procédé de fabrication d'un dispositif MOS, ce procédé comprenant un traitement suivant l'une quelconque des revendications 1 à 6.

# FIG. 1

# FIG. 2

Hole Trapping
RTA in $O_2$, 1000°C
POA: $N_2$, 1000°C, 17 hours

control

300 sec

10 sec

100 sec

-FLATBAND VOLTAGE SHIFT (V)

TIME (SEC)